(19) Europäisches Patentamt
European Patent Office
Office européen des brevets

(11) **EP 1 318 586 B1**

(12) **FASCICULE DE BREVET EUROPEEN**

(45) Date de publication et mention
de la délivrance du brevet:
**05.09.2012 Bulletin 2012/36**

(51) Int Cl.:
**H02H 3/44** *(2006.01)*   **G01R 31/02** *(2006.01)*

(21) Numéro de dépôt: **02354143.6**

(22) Date de dépôt: **16.09.2002**

(54) **Dispositif et procédé de détection de court-circuit électrique, et disjoncteur comportant un tel dispositif**

Vorrichtung und Verfahren zur elektrischen Kurzschlussdetektion und mit dieser Vorrichtung versehener Lastschalter

Method and device for electrical short circuit detection, and circuit breaker comprising such a device

(84) Etats contractants désignés:
**DE ES GB IT**

(30) Priorité: **06.12.2001 FR 0115785**

(43) Date de publication de la demande:
**11.06.2003 Bulletin 2003/24**

(73) Titulaire: **Schneider Electric Industries SAS
92500 Rueil-Malmaison (FR)**

(72) Inventeurs:
• **Leprettre, Benoit,
Schneider Electric Ind. SAS
38050 Grenoble Cédex 09 (FR)**

• **Oriat, Luc,
Schneider Electric Ind. SA
38050 Grenoble Cédex 09 (FR)**
• **Perichon, Pierre,
Schneider Electric Ind. SA
38050 Grenoble Cédex 09 (FR)**

(74) Mandataire: **Tripodi, Paul et al
Schneider Electric Industries SAS
Service Propriété Industrielle
World Trade Center - E1
5 Place Robert Schuman
38050 Grenoble Cedex 9 (FR)**

(56) Documents cités:
**DE-A- 19 839 616    US-B1- 6 313 639**

**Description**

**DOMAINE TECHNIQUE**

L'invention concerne un dispositif de détection de court-circuit électrique comportant

- des premiers moyens traitement de signal comportant une entrée pour recevoir un signal représentatif d'un courant électrique, une première sortie pour fournir un premier signal représentatif de la valeur dudit courant électrique et une seconde sortie pour fournir un second signal représentatif de la dérivée dudit courant électrique, et
- des seconds moyens de traitement recevant ledit premier signal et ledit second signal et comportant des moyens de détection de court-circuit fournissant un signal de détection de court-circuit en fonction d'un dépassement de courbe correspondant à des caractéristiques combinées de courant et de dérivée de courant.

L'invention concerne aussi un procédé de détection de court-circuit électrique utilisant une première valeur d'un premier signal représentatif de la valeur d'un courant électrique et d'une seconde valeur d'un second signal représentatif de la dérivée dudit courant électrique.
L'invention concerne aussi un disjoncteur comportant un tel dispositif ou mettant en oeuvre un tel procédé.

**ETAT DE LA TECHNIQUE**

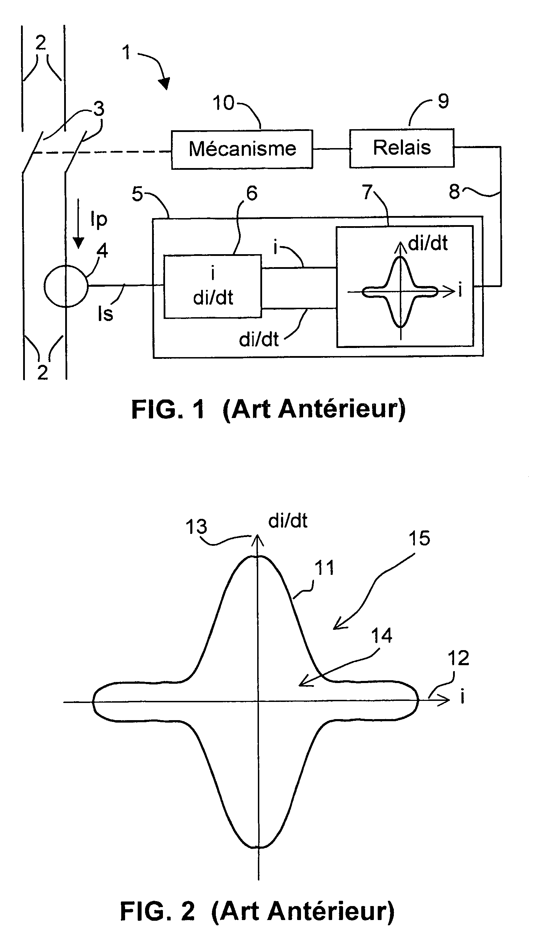

Il existe des dispositifs de détection de courts-circuits qui utilisent des signaux de dérivée de courant et des signaux de courant réel pour détecter un court circuit. Ces dispositifs utilisent une zone de non-déclenchement représentée dans un repère orthogonal avec un axe de dérivées de courant et un axe de courant réel. Dés qu'un passage à l'extérieur de la zone est franchi, un court-circuit est détecté. Si un courant représenté par un signal de dérivée et un signal de composante réelle reste à l'intérieur de la zone, il n'y a pas de détection de court circuit.
Une demande de brevet DE3642136 de l'état de la technique décrit un dispositif de détection utilisant des signaux de dérivée de courant di/dt et de signaux de courant i dans un déclencheur électronique pour détecter un court circuit. Ces signaux sont appliqués à un circuit de contrôle d'une zone de déclenchement définie dans un repère orthogonal.
Dans une demande brevet EP838887 et dans le brevet US5,905,615, il est décrit un disjoncteur comportant un détecteur de court-circuit utilisant des signaux de dérivée de courant $(di(t)/dt)/In$ et de signaux de courant $i(t)/In$. Ces signaux sont appliqués à un circuit de contrôle d'une zone sans court-circuit définie dans un repère orthogonal. Dans ce disjoncteur, le détecteur de court-circuit est associé à un dispositif de contrôle de sélectivité entre disjoncteur.
Des demandes de brevets DE19839616 et WO9903183 (correspondant à US 6313639) décrivent une méthode et un dispositif de détection utilisant des signaux de dérivée de courant di/dt et de signaux de courant i pour détecter un court-circuit dans un réseau basse tension. Ces signaux sont appliqués à un circuit de contrôle d'une zone sans court-circuit définie dans un repère orthogonal. Des formes particulières de zones sont définies dans le document WO99031183.
Un schéma représenté sur figure 1 montre un disjoncteur 1 comportant des conducteurs principaux 2 connectés à des contacts 3 de coupure permettant des couper un courant électrique Ip dans lesdits conducteurs 2. Un capteur de courant 4 disposé sur un conducteur 2 permet de fournir un signal Is représentatif d'un courant Ip circulant dans ledit conducteur. Le signal Is est fourni à un dispositif 5 de détection de court circuit. Ledit dispositif 5 comporte un circuit de traitement 6 de signal et un circuit de traitement 7 de détection de court circuit. Le circuit 6 a une entrée pour recevoir le signal Is représentatif d'un courant circulant dans un conducteur principal et deux sorties pour fournir des signaux au circuit 7. Une première sortie fournit un premier signal i représentatif de la valeur instantanée dudit courant Ip et une seconde sortie fournit un second signal di/dt représentatif de la dérivée dudit courant Ip.
Ledit circuit 7 de traitement reçoit les signaux i et di/dt et fournit un signal 8 de détection de court-circuit si une courbe correspondant à des caractéristiques combinées de courant et de dérivée de courant est dépassée. Le signal 8 peut commander un relais 9 de déclenchement d'un mécanisme 10 d'ouverture des contacts 3.
Une figure 2 montre un type de courbe combinée utilisée par des dispositifs de l'art antérieur. Sur cette figure, une courbe 11 combinée est tracée sur un repère orthogonal ayant un premier axe 12 portant des valeurs représentatives de courant i, et un second axe 13 perpendiculaire au premier axe 12 et portant des valeurs représentatives de dérivées de courant di/dt. Cette courbe 11 correspondant à des seuils variables en fonction des signaux i et di/dt, elle délimite une zone 14 de non-déclenchement à l'intérieur de ladite courbe et une zone 15 de déclenchement à l'extérieur de ladite courbe.
Les méthodes utilisées dans des dispositifs de l'état de la technique permettent une détection simple et efficace de courts-circuits mais la rapidité de décision n'est pas suffisante pour des dispositifs de détection très rapides. Pour certains appareils de coupure, les méthodes connues risquent de détecter un court-circuit alors que le courant est déjà trop élevé. Un tel retard risque de baisser les performances d'un appareil de coupure tel qu'un disjoncteur.

## EXPOSE DE L'INVENTION

L'invention a pour but un dispositif et un procédé de détection de court-circuit permettant une détection très rapide, et un disjoncteur comportant un tel appareil.

Dans un dispositif de détection selon l'invention les seconds moyens de traitement comportent des premiers moyens de contrôle pour contrôler un dépassement de courbe limite et des seconds moyens de contrôle pour déterminer une valeur représentative d'un rapport entre des variations de valeurs dépendant du premier signal et du second signal lorsque les premiers moyens de traitement détectent un dépassement de courbe limite, un signal de détection de court-circuit étant fourni si les premiers moyens de contrôle détectent un dépassement de ladite courbe limite et si les seconds moyens de contrôle détectent un rapport entre des variations dépassant une valeur de seuil prédéterminé.

De préférence, ladite valeur de seuil prédéterminé est égale ou inférieure à zéro.

Avantageusement, ladite valeur représentative dudit rapport entre des variations est définie par une valeur d'angle déterminée par une tangente à un point de dépassement de la courbe limite par d'un signal représentatif dudit premier signal représentatif de la valeur dudit courant électrique et dudit second signal représentatif de la dérivée dudit courant électrique.

De préférence, ladite courbe limite est formée par au moins deux segments.

Par exemple, la courbe limite comporte un premier segment commençant à un premier seuil de courant, finissant à un second seuil de courant, et formant un premier angle avec un premier axe représentatif de valeur de courant, et un second segment commençant audit second seuil.

De préférence, le second segment forme un second angle avec le premier axe, le second angle étant supérieur au premier angle.

Dans un autre mode de réalisation préférentiel, ladite courbe limite commence à un premier seuil et est définie par des couples de points prédéfinis.

Avantageusement, ladite courbe limite passe entre un gabarit défini par une première courbe et une seconde courbe,

ladite première courbe ayant un premier segment commençant à un premier seuil relatif de courant, finissant à un second seuil relatif de courant, et formant un premier angle avec un premier axe représentatif de valeur de courant, et un second segment commençant audit second seuil relatif et formant un second angle avec le premier axe, le second angle étant supérieur au premier angle,

ladite seconde courbe ayant un troisième segment commençant à un troisième seuil relatif de courant, finissant à un quatrième seuil relatif de courant, et formant un troisième angle avec un premier axe représentatif de valeur de courant, et un quatrième segment commençant audit quatrième seuil relatif et formant un quatrième angle avec le premier axe, le troisième seuil relatif étant supérieur au premier seuil relatif, le quatrième seuil relatif étant supérieur au second seuil relatif, et le troisième angle étant inférieur ou égal au premier angle.

De préférence, dans un repère orthonormé par rapport à un courant nominal de fonctionnement le premier seuil relatif est supérieur à 1, le second seuil relatif est supérieur à 3,3, le troisième seuil relatif est inférieur à 1,6, le quatrième seuil relatif est inférieur à 5,3, le premier angle est inférieur à 70 degrés, et le troisième angle est supérieur à 30 degrés.

Avantageusement, ladite courbe limite est formée de manière sensiblement symétrique sur un premier quadrant de valeurs positives de courant et de dérivée de courant, et sur un troisième quadrant de valeurs négatives de courant et de dérivée de courant.

Un disjoncteur électrique selon l'invention comporte des contacts de puissance pour couper un courant électrique dans des conducteurs électriques, et un déclencheur électronique comprenant des capteurs de courant pour fournir des signaux représentatifs de courants circulant dans les conducteurs électriques, des moyens de traitement de fonction de déclenchement recevant desdits signaux représentatifs de courants circulant dans lesdits conducteurs électriques et fournissant un signal de déclenchement à un relais de déclenchement de l'ouverture desdits contacts électriques, le déclencheur comportant au moins un dispositif de détection de court-circuit tel que défini ci-dessus pour fournir un signal de déclenchement si un court-circuit est détecté.

Un procédé de détection d'un court-circuit électrique selon l'invention comporte :

- une première étape de détermination d'une première valeur d'un premier signal représentatif de la valeur d'un courant électrique et d'une seconde valeur d'un second signal représentatif de la dérivée dudit courant électrique,
- une étape de contrôle du dépassement d'une courbe limite par ladite première valeur et ladite seconde valeur,
- une seconde étape de détermination pour déterminer une valeur représentative d'un rapport entre des variations de ladite seconde valeur dudit second signal et des variations de ladite première valeur du second signal, et
- une étape de contrôle de la valeur représentative dudit rapport entre des variations pour fournir un ordre de détection de court-circuit si ladite valeur représentative d'un rapport dépasse une valeur de seuil prédéterminé.

Avantageusement, dans la seconde étape de détermination, la valeur représentative dudit rapport est déterminée en fonction :

- d'une première différence entre un échantillon dudit second signal proche d'un moment de dépassement de la courbe et un des échantillons précédents dudit second signal, et
- d'une seconde différence entre un échantillon dudit premier signal proche dudit moment de dépassement de la courbe limite et un des échantillons précédents dudit premier signal.

De préférence, dans la seconde étape de détermination, la valeur représentative dudit rapport est représentative d'une tangente formée environ au moment d'un croisement de la courbe limite par une courbe représentant le premier signal et le second signal dans un repère sensiblement orthogonal.

Selon une variante, dans la seconde étape de détermination, la valeur représentative dudit rapport est représentative d'un angle formé par un vecteur représentatif d'une tangente environ au moment d'un croisement de la courbe limite par une courbe représentant le premier signal et le second signal dans un repère sensiblement orthogonal et un vecteur parallèle à un axe représentatif de valeur de courant.

De préférence, dans l'étape de contrôle du dépassement d'une courbe limite la courbe limite comporte au moins deux segments.

Avantageusement, dans étape de contrôle du dépassement d'une courbe limite la courbe limite est définie par des couples de points prédéterminés.

## BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

- la figure 1 représente un schéma d'un disjoncteur avec un dispositif de détection de court-circuit de l'art antérieur ;
- la figure 2 représente un graphique d'une courbe de seuil de détection de l'art antérieur ;
- la figure 3 représente un dispositif de détection selon un mode de réalisation de l'invention ;
- la figure 4 représente un graphique de fonctionnement d'un dispositif de détection selon un mode de réalisation de l'invention ;
- le figure 5 représente un graphique d'une courbe limite pour un dispositif selon un mode de réalisation de l'invention comportant deux segments ;
- la figure 6 montre une courbe de la figure 5 représentée sur deux quadrants ;
- la figure 7 représente un graphique d'une courbe limite pour un dispositif selon un mode de réalisation de l'invention comportant trois segments ;
- la figure 8 représente un graphique d'une courbe limite de forme complexe pour un dispositif selon un mode de réalisation de l'invention ;
- la figure 9 représente un graphique d'une courbe limite et des gabarits préférentiels de courbe limite ;
- la figure 10 représente un graphique de valeurs préférentielles d'angles et de tangentes de seuils ;
- la figure 11 représente un organigramme d'un procédé de détection d'un court-circuit selon un mode de réalisation de l'invention ;
- la figure 12 représente un schéma d'un disjoncteur selon un mode réalisation de l'invention comportant un dispositif selon une variante de celui de la figure 3.

## DESCRIPTION DETAILLEE DE MODES DE REALISATION PREFERES

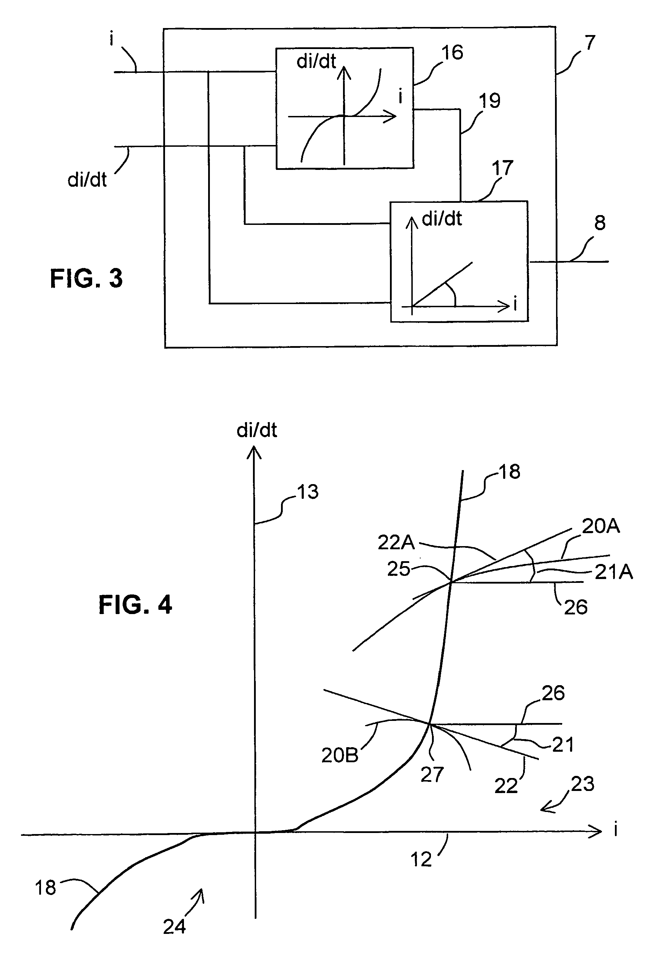

Le dispositif de détection selon un mode de réalisation de l'invention représenté sur la figure 3 comporte un circuit 7 de traitement de détection de court-circuit comportant un premier module 16 de contrôle pour contrôler un dépassement de courbe limite et un second module 17 de contrôle pour déterminer une valeur représentative d'un rapport entre des variations de valeurs dépendant du premier signal i et du second signal di/dt lorsque le premier module 16 a détecté un dépassement de courbe limite. Un signal 8 de détection de court-circuit est fourni si le premier module de contrôle 16 détecte un dépassement de ladite courbe limite et si le second module 17 de contrôle détecte un rapport entre les variations des signaux i et di/dt dépassant une valeur prédéterminée.

Dans le mode de réalisation particulier de la figure 3, le module 16 détecte le dépassement d'une courbe limite 18 et fournit un signal de contrôle 19 au circuit 17 pour valider le calcul d'un rapport entre des variations du signal i et des variations du signal di/dt à un instant proche d'un instant de dépassement de la courbe limite 18. Si le rapport dépasse une valeur prédéterminée un signal de détection de court-circuit est fourni. Le rapport entre des variations du signal i et des variations du signal di/dt peut être représenté notamment par une tangente 22 d'une courbe 20 représentant les signaux i et di/dt, par un angle 21 que forme une tangente 22 avec une parallèle 26 à l'axe 12, par des variations de valeurs entre des échantillons d'un signal di/dt et des variations de valeurs entre des échantillons d'un signal i à un instant proche d'un instant de dépassement de la courbe limite 18.

La figure 4 illustre un fonctionnement d'un dispositif de détection de détection de court-circuit selon un mode de réalisation de l'invention. Une courbe limite 18 est définie sur un premier quadrant 23 et un troisième quadrant 24 d'un repère orthogonal ayant des axes 12 et 13. Une première courbe 20A représentant des signaux i et di/dt a une forte croissance et croise la courbe 18 en un point 25 à un instant de dépassement. Le dispositif contrôle alors le rapport entre des variations du signal di/dt et des variations du signal i. Sur cette courbe, le rapport peut être représenté par une tangente 22A, un angle 21A entre la tangente 22A et une parallèle 26 à l'axe 12. Dans ce cas, le rapport est élevé et un signal 8 de détection de court-circuit est fournit si une valeur prédéterminée de rapport est dépassée. Par exemple, une valeur prédéterminée de seuil de rapport peut être zéro. Cette valeur de seuil correspond aussi à une tangente de seuil ou à un angle seuil de valeur prédéterminée zéro. Une seconde courbe 20B représente une autre situation de fonctionnement, elle croise la courbe 18 en un point 27. Lors du dépassement, le rapport entre des variations du signal di/dt et des variations du signal i est inférieur à zéro. La tangente 22 est négative ainsi que l'angle 21. Dans ce cas, le rapport est négatif et un signal 8 de détection de court-circuit n'est pas fourni puisqu'une valeur prédéterminée de rapport n'est pas dépassée.

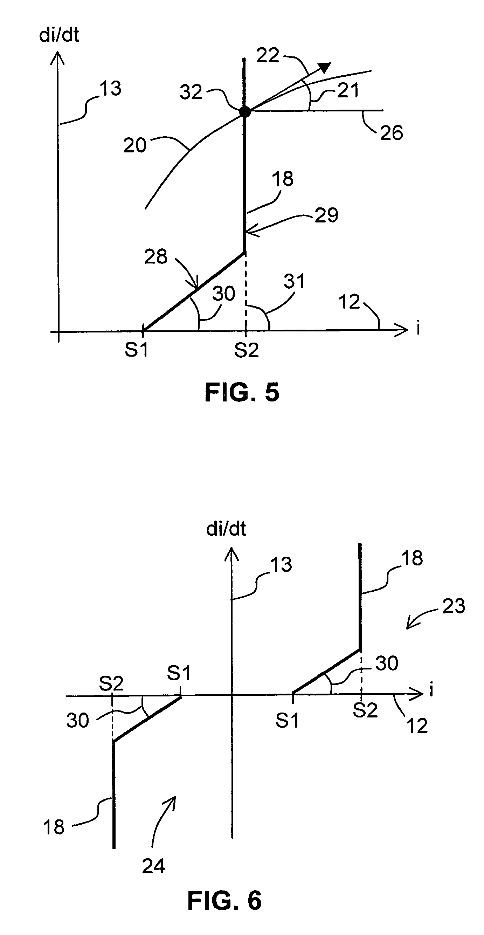

Sur la figure 5, une courbe limite 18 est formée par deux segments. Par exemple, un premier segment 28 commence à un premier seuil de courant S1, finit à un second seuil de courant S2 et forme un premier angle 30 avec un premier axe 12 représentatif de valeur de courant i. Un second segment 29 commence au second seuil S2 et forme un second angle 31 avec l'axe 12, le second angle 31 étant supérieur au premier angle 30. Sur cette figure, la courbe 20 représentant les signaux i et di/dt dépasse la courbe limite 18 sur le second segment 29 au point 32. A ce moment, le rapport des variations des signaux i et di/dt est utilisé pour fournir un signal de détection de court-circuit si un seuil est dépassé. La variation pouvant être représentée par la tangente 22 ou l'angle 21.

Une courbe limite 18, représentée sur la figure 6, est définie sur un premier quadrant 23 et sur le troisième quadrant 24 d'un repère orthongonal d'axes 12 et 13.

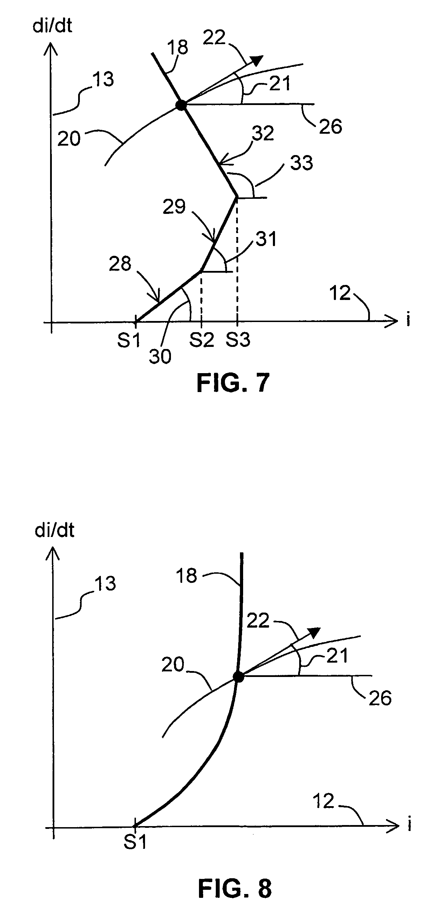

Sur la figure 7, une courbe limite 18 est formée par trois segments. Par exemple, un premier segment 28 commence à un premier seuil de courant S1, finit à un second seuil de courant S2 et forme un premier angle 30 avec un premier axe 12 représentatif de valeur de courant i. Un second segment 29 commence au second seuil S2, finit à un troisième seuil S3, et forme un second angle 31 avec l'axe 12, le second angle 31 étant supérieur au premier angle 30. Un troisième segment 32 commence au troisième seuil S3 et forme un troisième angle 33 avec l'axe 12 ou une parallèle à l'axe 12.

De préférence, le second angle 31 est supérieur au premier angle 30, et le troisième angle 33 est supérieur au second angle 31.

Dans un autre mode de réalisation, représenté sur la figure 8, la courbe limite 18 a une forme complexe pouvant être définie par calcul ou de préférence par une table de couples de points prédéfinis de valeurs de signaux i et di/dt.

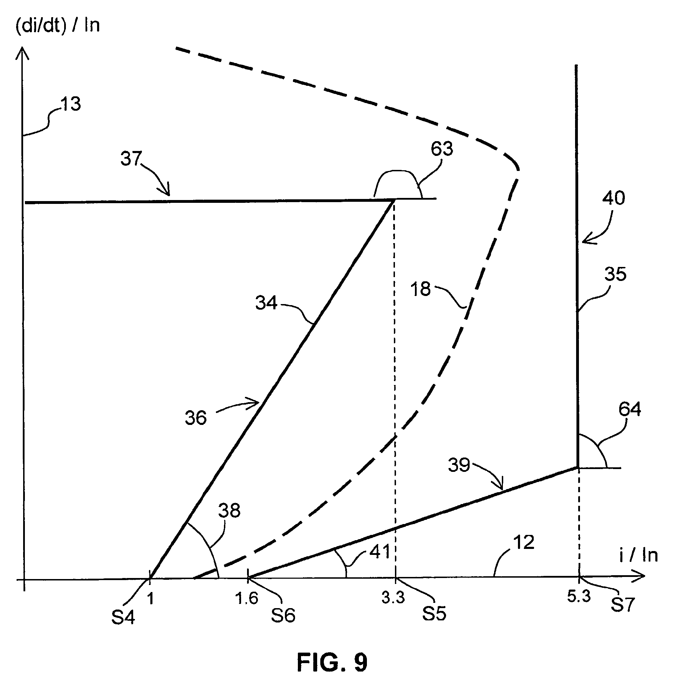

La figure 9 montre des plages de valeurs préférentielles de courbes limites 18 représentées dans un repère orthogonal d'axes 12 et 13. Les valeurs sont normées par rapport à un courant nominal In pouvant correspondre à un courant de nominal d'un relais de protection ou d'un disjoncteur. Dans ce cas, l'axe 12 porte des valeurs de i/In et l'axe 13 porte des valeurs de (di/dt)/In. Dans ce repère, la courbe limite 18 est avantageusement comprise entre un gabarit formé par deux courbes 34 et 35.

La première courbe 34 de gabarit comporte deux segments 36 et 37. Le premier segment 34 commence à un premier seuil relatif S4 de valeur 1 disposé sur l'axe 12, finit à un second seuil relatif S5 de valeur 3,3, et forme un angle 38 de 70 degrés avec l'axe 12. le second segment 37 commence au second seuil relatif S5 et forme un angle 63 par rapport à l'axe 12. La seconde courbe 35 de gabarit comporte deux segments 39 et 40. Le premier segment 34 commence à un premier seuil relatif S6 de valeur 1,6 disposé sur l'axe 12, finit à un second seuil relatif S7 de valeur 5,3, et forme un angle 41 de 30 degrés avec l'axe 12. le second segment 40 commence au second seuil relatif S7 et forme un angle 64 par rapport à l'axe 12. Dans un tel repère, le seuil S1 d'une courbe 18 est de préférence compris entre des valeurs 1 et 1,6 de i/In. A l'intérieur du repère la courbe 18 peut avoir des formes diverses, par exemple elle peut être formée par des segments, par des formes géométriques telles que des paraboles ou des hyperboles, ou par des tables de couples de points prédéfinis ainsi que des interpolations entre des couples de points prédéfinis.

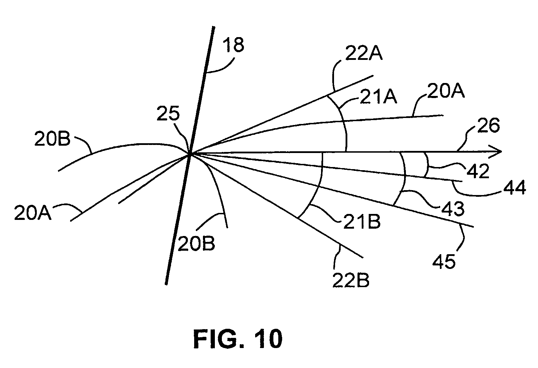

Pour chaque courbe de gabarit, il est possible aussi de définir un seuil d'angle pour comparer l'angle 21 ou la valeur du rapport entre des variations des signaux di/dt et i et fournir un signal de détection si le seuil est dépassé. La figure 10 montre des seuils d'angle ou de tangente pouvant être utilisés dans des dispositifs selon des modes de réalisation de l'invention. Par exemple, pour la courbe de gabarit 34 un seuil d'angle 42 peut être de -0,1 radiant ou -5,7 degrés et pour la courbe 35 un seuil d'angle 43 peut être de -0,3 radiants ou -17 degrés. Sur la figure 10, les seuils d'angles correspondent à des seuils de tangente respectivement 44 et 45. Une première courbe 20A, représentant des signaux i et di/dt, a une tangente supérieure aux tangentes de seuil 43 ou 44, et un angle 21A supérieur aux angles de seuils 42 ou 43. Dans ce cas, un signal de détection de court-circuit peut être fournit. Une seconde courbe 20B, représentant des signaux i et di/dt, a une tangente 22B inférieure aux tangentes de seuil 43 ou 44, et un angle 21B inférieur aux angles de seuils 42 ou 43. Dans ce cas, le signal de détection de court-circuit n'est pas fourni.

Les valeurs de seuils, de tangentes et d'angles des modes de réalisations décrits ci-dessus sont définis pour un premier quadrant d'un repère orthonormé, mais d'autres valeurs sont possibles pour un troisième quadrant en adaptant les signes des seuils, des tangentes, et des angles ainsi que le sens de dépassement vers des valeurs négatives.

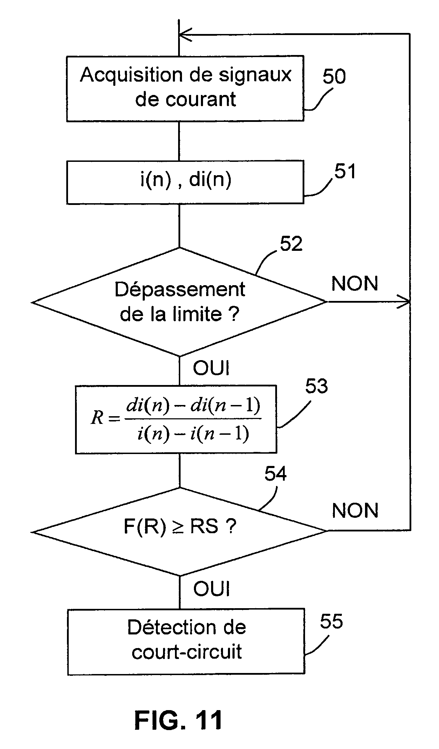

Un organigramme, représenté sur la figure 11, montre un procédé de détection de court-circuit selon un mode de réalisation de l'invention. Dans cet organigramme, une première étape 50 permet l'acquisition de valeurs de signaux de courant ou de dérivées de valeurs de courant. Cette acquisition peut être faite sous la forme d'échantillonnage à l'aide d'un convertisseur. Une étape 51 permet de déterminer des valeurs de courant i et de dérivée de courant di/dt ou de valeurs correspondantes en échantillons respectivement i(n) et di(n). Une étape 52 permet le contrôle du dépassement de la courbe limite 18 ou de couples de valeurs limites par des signaux de courants i ou i(n) et de dérivés de courant di/dt ou di(n). Si l'étape 52 détecte un dépassement de la courbe limite, une étape 53 évalue un rapport entre les variations des signaux de dérivée courant et des signaux de courant. Par exemple, pour des signaux échantillonnés, les variations peuvent être déterminées en fonction des échantillons précédents des signaux de la dérivée de courant et du courant respectivement di(n-1) et i(n-1). Ainsi, la variation de la dérivée de courant peut être exprimée par di(n) - di(n-1) et la variation de courant par i(n) - i(n-1). L'expression du rapport peut alors être de la forme R = ((di(n) - di(n-1)) / (i(n) - i(n-1))). Une étape 54 compare le rapport R ou une fonction du rapport f(R) à un seuil RS. Ce seuil peut être aussi un seuil de tangente si la fonction f(R) fournit une valeur de tangente ou un seuil d'angle si la fonction f(R) fournit une valeur d'angle. Par exemple, une fonction f(R) fournissant un angle peut être formulée par :

$$f(R) = \text{Arc tangente } ((di(n) - di(n-1)) / (i(n) - i(n-1)))$$

Si le seuil RS est dépassé, une étape 55 indique la détection d'un court-circuit.

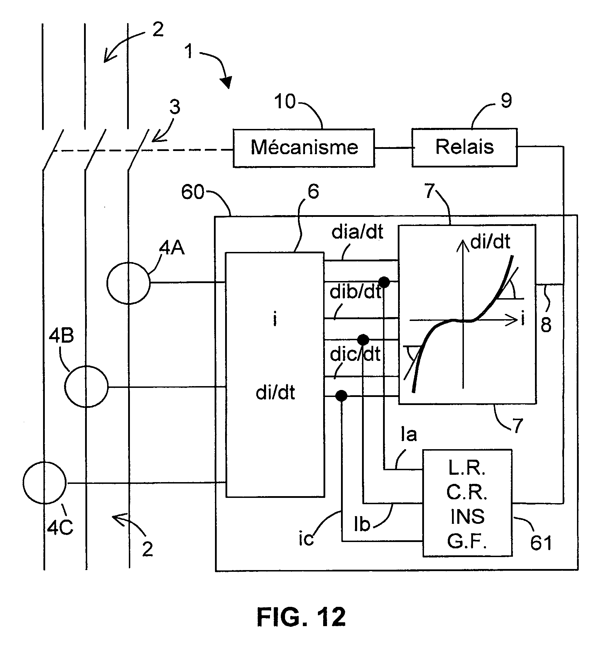

La figure 12 montre un schéma d'un disjoncteur selon un mode de réalisation de l'invention comportant un dispositif de détection de court-circuit fonctionnant en triphasé.

Le disjoncteur 1 comporte des conducteurs principaux 2 connectés à des contacts 3 de coupure permettant des couper un courant électrique dans lesdits conducteurs 2. Des capteurs de courant 4A, 4B, 4C disposés sur les conducteurs 2 permettent de fournir à un déclencheur 60 des signaux représentatifs des courants circulant dans lesdits conducteurs. Ledit déclencheur 60 comporte un circuit de traitement 6 de signaux et un circuit de traitement 7 de détection de court circuit. Le circuit 6 reçoit les signaux représentatifs des courants circulant dans les conducteurs principaux et des sorties pour fournir au circuit 7 des signaux ia, ib, ic représentatif des valeurs instantanées des courants et signaux dia/dt, dib/dt et dic/dt représentatifs des dérivées desdits courants.

Ledit circuit 7 de traitement reçoit les signaux ia, ib, ic et dia/dt, dib/dt et dic/dt et fournit un signal 8 de détection de court-circuit notamment dans des conditions définies dans des modes de réalisation décrits ci-dessus.

Le schéma de la figure 12 comporte aussi un circuit de traitement 61 de fonctions déclenchement recevant des signaux de courant ia, ib, ic et/ou des signaux de dérivées de courant dia/dt, dib/dt et dic/dt. Les fonctions de déclenchement sont notamment des fonctions de long retard ou thermique, de court retard, d'instantanés, et/ou de protection terre.

Les capteurs de courant sont de préférence des capteurs à tores de Rogowski ou des capteurs à shunt électrique qui permettent une réponse en courant rapide. Les circuits peuvent être réalisés en composants discrets ou de préférence sous une forme programmée et intégrée dans un microcontrôleur.

## Revendications

1. Dispositif de détection de court-circuit électrique comportant :

- des premiers moyens (6) traitement de signal comportant une entrée pour recevoir un signal (Is) représentatif d'un courant électrique, une première sortie pour fournir un premier signal (i, ia, ib, ic) représentatif de la valeur dudit courant électrique et une seconde sortie pour fournir un second signal (di/dt, dia/dt, dib/dt, dic/dt) représentatif de la dérivée dudit courant électrique, et

- des seconds moyens (7) de traitement recevant ledit premier signal (i, ia, ib, ic) et ledit second signal (di/dt, dia/dt, dib/dt, dic/dt) et comportant des moyens de détection de court-circuit fournissant un signal (8) de détection de court-circuit en fonction d'un dépassement de courbe correspondant à des caractéristiques combinées de courant et de dérivée de courant,

dispositif **caractérisé en ce que** les seconds moyens (7) de traitement comportent des premiers moyens (16) de contrôle pour contrôler un dépassement de courbe limite (18) et des seconds moyens (17) de contrôle pour déterminer une valeur (21, 22, 21 A, 22A, 21B, 22B, R, f(R)) représentative d'un rapport entre des variations de valeurs dépendant du premier signal (i, ia, ib, ic) et du second signal (di/dt, dia/dt, dib/dt, dic/dt) lorsque les premiers moyens (16) de traitement détectent un dépassement de courbe (18) limite, un signal (8) de détection de court-circuit étant fourni si les premiers moyens (16) de contrôle détectent un dépassement de ladite courbe limite et si les seconds moyens (17) de contrôle détectent un rapport (21, 22, 21A, 22A, 21B, 22B, R, f(R)) entre des variations dépassant une valeur de seuil (42, 43, 44, 45, RS) prédéterminé.

2. Dispositif de détection selon la revendication 1 **caractérisé en ce que** ladite valeur de seuil prédéterminé (42, 43, 44, 45, RS) est égale ou inférieure à zéro.

3. Dispositif de détection selon l'une des revendications 1 ou 2 **caractérisé en ce que** ladite valeur représentative dudit rapport (21, 22, 21A, 22A, 21B, 22B, R, f(R)) entre des variations est définie par une valeur d'angle (21, 21 A, 21B) déterminée par une tangente (22, 22A, 228) à un point (25) de dépassement de la courbe (18) limite par d'un signal (20, 20A, 20B) représentatif dudit premier signal représentatif de la valeur dudit courant électrique et dudit second signal représentatif de la dérivée dudit courant électrique.

4. Dispositif de détection selon l'une quelconque des revendications 1 à 3 **caractérisé en ce que** ladite courbe limite (18) est formée par au moins deux segments (28, 29).

5. Dispositif de détection selon la revendication 4 **caractérisé en ce que** la courbe limite (18) comporte :

   - un premier segment (28) commençant à un premier seuil (S1) de courant, finissant à un second seuil (S2) de courant, et formant un premier angle (30) avec un premier axe (12) représentatif de valeur de courant, et
   - un second segment (29) commençant audit second seuil (S2).

6. Dispositif de détection selon la revendication 5 **caractérisé en ce que** le second segment (29) forme un second angle (31) avec le premier axe (12), le second angle (31) étant supérieur au premier angle (30).

7. Dispositif de détection selon l'une quelconque des revendications 1 à 3 **caractérisé en ce que** ladite courbe limite (18) commence à un premier seuil (S1) et est définie par des couples de points prédéfinis.

8. Dispositif de détection selon l'une quelconque des revendications 1 à 7 **caractérisé en ce que** ladite courbe limite passe entre un gabarit défini par une première courbe (34) et une seconde courbe (35), ladite première courbe (34) ayant un premier segment (36) commençant à un premier seuil relatif (S4) de courant, finissant à un second seuil relatif (S5) de courant, et formant un premier angle (38) avec un premier axe (12) représentatif de valeur de courant, et un second segment (37) commençant audit second seuil relatif (S5) et formant un second angle (63) avec le premier axe, le second angle étant supérieur au premier angle, ladite seconde courbe ayant un troisième segment (39) commençant à un troisième seuil relatif (S6) de courant, finissant à un quatrième seuil relatif (S7) de courant, et formant un troisième angle (41) avec un premier axe (12) représentatif de valeur de courant, et un quatrième segment (40) commençant audit quatrième seuil relatif (S7) et formant un quatrième angle (64) avec le premier axe, le troisième seuil relatif (S6) étant supérieur au premier seuil relatif (S4), le quatrième seuil relatif (S7) étant supérieur au second seuil relatif (S6), et le troisième angle (41) étant inférieur ou égal au premier angle (38).

9. Dispositif de détection selon la revendication 8 **caractérisé en ce que** dans un repère orthonormé par rapport à un courant nominal de fonctionnement :

   - le premier seuil relatif (S4) est supérieur à 1,
   - le second seuil relatif (S5) est supérieur à 3,3,
   - le troisième seuil relatif (S6) est inférieur à 1,6,
   - le quatrième seuil relatif (S7) est inférieur à 5,3.
   - le premier angle (38) est inférieur à 70 degrés, et
   - le troisième angle (41) est supérieur à 30 degrés.

**10.** Dispositif de détection selon l'une quelconque des revendications 1 à 9 **caractérisé en ce que** ladite courbe limite (18) est formée de manière sensiblement symétrique sur un premier quadrant (23) de valeurs positives de courant et de dérivée de courant, et sur un troisième quadrant (24) de valeurs négatives de courant et de dérivée de courant.

**11.** Disjoncteur électrique comportant des contacts (3) de puissance pour couper un courant électrique dans des conducteurs électriques (2), et un déclencheur électronique (60) comprenant des capteurs (4, 4A, 4B, 4C) de courant pour fournir des signaux représentatifs de courants circulant dans les conducteurs électriques, des moyens de traitement de fonction de déclenchement (6, 7, 61) recevant desdits signaux représentatifs de courants circulant dans lesdits conducteurs électriques et fournissant un signal (8) de déclenchement à un relais (9) de déclenchement de l'ouverture desdits contacts électriques,
**caractérisé en ce que** le déclencheur (60) comporte au moins un dispositif (7) de détection de court-circuit selon l'une quelconque des revendications 1 à 10 pour fournir un signal (8) de déclenchement si un court-circuit est détecté.

**12.** Procédé de détection de court-circuit électrique comportant :

- une première étape (51) de détermination d'une première valeur d'un premier signal (i, ia, ib; ic, i(n)) représentatif de la valeur d'un courant électrique et d'une seconde valeur d'un second signal (di/dt, dia/dt, dib/dt; dic/dt, di (n)) représentatif de la dérivée dudit courant électrique,
- une étape (52) de contrôle du dépassement d'une courbe limite (18) par ladite première valeur et ladite seconde valeur,
- une seconde étape (53) de détermination pour déterminer une valeur représentative d'un rapport (R) entre des variations de ladite seconde valeur dudit second signal et des variations de ladite première valeur du premier signal, et
- une étape (54) de contrôle de la valeur représentative dudit rapport (R, f(R)) entre des variations pour fournir un ordre de détection de court-circuit si ladite valeur représentative d'un rapport dépasse une valeur de seuil (RS) prédéterminé.

**13.** Procédé de détection selon la revendication 12 **caractérisé en ce que** dans la seconde étape (53) de détermination, la valeur représentative dudit rapport (R) est déterminée en fonction :

- d'une première différence (di(n)-di(n-1)) entre un échantillon (di(n)) dudit second signal proche d'un moment de dépassement de la courbe et un des échantillons précédents (di(n-1)) dudit second signal, et
- d'une seconde différence (i(n)-i(n-1)) entre un échantillon (i(n)) dudit premier signal proche dudit moment de dépassement de la courbe limite et un des échantillons précédents (i(n-1)) dudit premier signal.

**14.** Procédé de détection selon l'une des revendications 12 ou 13 **caractérisé en ce que** dans la seconde étape (53) de détermination, la valeur (f(R)) représentative dudit rapport (R) est représentative d'une tangente formée environ au moment d'un croisement de la courbe limite par une courbe représentant le premier signal et le second signal dans un repère sensiblement orthogonal.

**15.** Procédé de détection selon des revendications 12 ou 13 **caractérisé en ce que** dans la seconde étape de détermination, la valeur ((f(R)) représentative dudit rapport (R) est représentative d'un angle (21, 21A, 21B) formé par un vecteur représentatif une tangente (22, 22A, 22B) environ au moment d'un croisement de la courbe limite (18) par une courbé (20, 20A, 20B) représentant le premier signal et le second signal dans un repère sensiblement orthogonal et un vecteur parallèle à un axe (12) représentatif de valeurs de courant.

**16.** Procédé de détection selon l'une quelconque des revendications 12 à 15 **caractérisé en ce que** dans l'étape (52) de contrôle du dépassement d'une courbe limite (18), la courbe limite comporte au moins deux segments (28, 29).

**17.** Procédé de détection selon l'une quelconque des revendications 12 à 16 **caractérisé en ce que** dans l'étape (52) de contrôle du dépassement d'une courbe limite (18), la courbe limite est définie par des couples de points prédéterminés.

**Claims**

**1.** A device for detecting an electric short-circuit comprising:

- first signal processing means (6) comprising an input to receive a signal (Is) representative of an electric current, a first output to supply a first signal (i, ia, ib, ic) representative of the value of said electric current and a second output to supply a second signal (di/dt, dia/dt, dib/dt, dic/dt) representative of the differential of said electric current, and

- second processing means (7) receiving said first signal (i, ia, ib, ic) and said second signal (di/dt, dia/dt, dib/dt, dic/dt) and comprising short-circuit detection means supplying a short-circuit detection signal (8) according to a curve overshoot corresponding to combined current and current differential characteristics,

a device **characterized in that** the second processing means (7) comprise first monitoring means (16) to monitor a limit curve overshoot (18) and second monitoring means (17) to determine a value (21, 22, 21 A, 22A, 21 B, 22B, R, f(R)) representative of a ratio between variations of values depending on the first signal (i, ia, ib, ic) and the second signal (di/dt, dia/dt, dib/dt, dic/dt) when the first processing means (16) detect a limit curve overshoot (18), a short-circuit detection signal (8) being supplied if the first monitoring means (16) detect an overshoot of said limit curve and if the second monitoring means (17) detect a ratio (21, 22, 21 A, 22A, 21 B, 22B, R, f(R)) between variations exceeding a preset threshold value (42, 43, 44, 45, RS).

2. The detection device according to claim 1 **characterized in that** said preset threshold value (42, 43, 44, 45, RS) is equal to or less than zero.

3. The detection device according to one of claims 1 or 2 **characterized in that** said value representative of said ratio (21, 22, 21 A, 22A, 21 B, 22B, R, f(R)) between variations is defined by an angle value (21, 21 A, 21 B) determined by a tangent (22, 22A, 22B) at an overshoot point (25) of the limit curve (18) by a signal (20, 20A, 20B) representative of said first signal representative of the value of said electric current and of said second signal representative of the differential of said electric current.

4. The detection device according to any one of claims 1 to 3 **characterized in that** said limit curve (18) is formed by at least two segments (28, 29).

5. The detection device according to claim 4 **characterized in that** the limit curve (18) comprises:

   - a first segment (28) starting at a first current threshold (S1), ending at a second current threshold (S2), and forming a first angle (30) with a first axis (12) representative of current value, and
   - a second segment (29) starting at said second threshold (S2).

6. The detection device according to claim 5 **characterized in that** the second segment (29) forms a second angle (31) with the first axis (12), the second angle (31) being larger than the first angle (30).

7. The detection device according to any one of claims 1 to 3 **characterized in that** said limit curve (18) starts at a first threshold (S1) and is defined by couples of predefined points.

8. The detection device according to any one of claims 1 to 7 **characterized in that** said limit curve passes between bounds defined by a first curve (34) and a second curve (35),
   said first curve (34) having a first segment (36) starting at a first relative current threshold (S4), ending at a second relative current threshold (S5), and forming a first angle (38) with a first axis (12) representative of current value, and a second segment (37) starting at said second relative threshold (S5) and forming a second angle (63) with the first axis, the second angle being larger than the first angle, said second curve having a third segment (39) starting at a third relative current threshold (S6), ending at a fourth relative current threshold (S7), and forming a third angle (41) with a first axis (12) representative of current value, and a fourth segment (40) starting at said fourth relative threshold (S7) and forming a fourth angle (64) with the first axis,
   the third relative threshold (S6) being greater than the first relative threshold (S4), the fourth relative threshold (S7) being greater than the second relative threshold (S5), and the third angle (41) being smaller than or equal to the first angle (38).

9. The detection device according to claim 8 **characterized in that** in a coordinates system orthonormed with respect to a nominal operating current:

   - the first relative threshold (S4) is higher than 1,
   - the second relative threshold (S5) is higher than 3.3,

- the third relative threshold (S6) is lower than 1.6,
- the fourth relative threshold (S7) is lower than 5.3,
- the first angle (38) is smaller than 70 degrees, and
- the third angle (41) is larger than 30 degrees.

10. The detection device according to any one of claims 1 to 9 **characterized in that** said limit curve (18) is formed in substantially symmetric manner on a first quadrant (23) of positive current and current differential values, and on a third quadrant (24) of negative current and current differential values.

11. An electric circuit breaker comprising power contacts (3) to interrupt an electric current in electric conductors (2), and an electronic trip device (60) comprising current sensors (4, 4A, 4B, 4C) to supply signals representative of currents flowing in the electric conductors, trip function processing means (6, 7, 61) receiving said signals representative of currents flowing in said electric conductors and supplying a trip signal (8) to a trip relay (9) triggering opening of said electric contacts,
**characterized in that** the trip device (60) comprises at least one short-circuit detection device (7) according to any one of claims 1 to 10 to supply a trip signal (8) if a short-circuit is detected.

12. A method for detecting an electric short-circuit comprising:

- a first step (51) of determining a first value of a first signal (i, ia, ib; ic, i(n)) representative of the value of an electric current and a second value of a second signal (di/dt, dia/dt, dib/dt; dic/dt, di(n)) representative of the differential of said electric current,
- a monitoring step (52) of overshoot of a limit curve (18) by said first value and said second value,
- a second determination step (53) to determine a value representative of a ratio (R) between variations of said second value of said second signal and variations of said first value of the first signal, and
- a monitoring step (54) of the value representative of said ratio (R, f(R)) between variations to supply a short-circuit detection order if said value representative of a ratio exceeds a preset threshold value (RS).

13. The detection method according to claim 12 **characterized in that**, in the second determination step (53), the value representative of said ratio (R) is determined according to:

- a first difference (di(n)-di(n-1)) between a sample (di(n)) of said second signal close to an overshoot time of the curve and one of the previous samples (di(n-1)) of said second signal, and
- a second difference (i(n)-i(n-1)) between a sample (i(n)) of said first signal close to said overshoot time of the limit curve and one of the previous samples (i(n-1)) of said first signal.

14. The detection method according to one of claims 12 or 13 **characterized in that**, in the second determination step (53), the value (f(R)) representative of said ratio (R) is representative of a tangent formed approximately at the time the limit curve is crossed by a curve representing the first signal and the second signal in an appreciably orthogonal coordinates system.

15. The detection method according to claim 12 or 13 **characterized in that**, in the second determination step, the value (f(R)) representative of said ratio (R) is representative of an angle (21, 21 A, 21 B) formed by a vector representative of a tangent (22, 22A, 22B) approximately at the time the limit curve (18) is crossed by a curve (20, 20A, 20B) representing the first signal and the second signal in an appreciably orthogonal coordinates system and a vector parallel to an axis (12) representative of current values.

16. The detection method according to any one of claims 12 to 15 **characterized in that**, in the monitoring step (52) of overshoot of a limit curve (18), the limit curve comprises at least two segments (28, 29).

17. The detection process according to any one of claims 12 to 16 **characterized in that**, in the monitoring step (52) of overshoot of a limit curve (18), the limit curve is defined by predefined couples of points.

**Patentansprüche**

1. Einrichtung zur Kurzschlusserkennung, umfassend

- erste Signalverarbeitungsmittel (6) mit einem Eingang zur Aufnahme eines einen elektrischen Strom abbildenden Signals (Is), einem ersten Ausgang zur Lieferung eines den Wert des genannten elektrischen Stroms abbildenden ersten Signals (i, ia, ib, ic) sowie einem zweiten Ausgang zur Lieferung eines, die Steilheit des genannten elektrischen Stroms abbildenden zweiten Signals (di/dt, dia/dt, dib/dt, dic/dt), sowie

- zweite Verarbeitungsmittel (7), die das genannte erste Signal (i, ia, ib, ic) sowie das genannte zweite Signal (di/dt, dia/dt, dib/dt, dic/dt) aufnehmen und Kurzschluss-Erkennungsmittel umfassen, welche ein Kurzschluss-sErkennungssignal in Abhängigkeit von der Überschreitung einer Kurve umfassen, die einer Kombination von Strom- und Stromsteilheits-Kennwerten entspricht,

**dadurch gekennzeichnet, dass** die zweiten Verarbeitungsmittel (7) erste Prüfmittel (16) zur Überprüfung der Überschreitung einer Grenzkurve (18) sowie zweite Prüfmittel (17) zur Bestimmung eines Werts (21, 22, 21A, 22A, 21 B, 22B, R, f(R)) umfassen, der ein Verhältnis zwischen, vom ersten Signal (i, ia, ib, ic) und vom zweiten Signal (di/dt, dia/dt, dib/dt, dic/dt) abhängenden Werteänderungen abbildet, wenn die ersten Verarbeitungsmittel (16) eine Überschreitung der Grenzkurve (18) erkennen, wobei ein Kurzschlusserkennungssignal (8) geliefert wird, wenn die ersten Prüfmittel (16) eine Überschreitung der genannten Grenzkurve erkennen und wenn die zweiten Prüfmittel (17) ein Verhältnis (21, 22, 21 A, 22A, 21 B, 22B, R, f(R)) zwischen Werteänderungen erkennen, das einen festgelegten Schwellwert (42, 43, 44, 45, RS) überschreitet.

2. Erkennungseinrichtung nach Anspruch 1, **dadurch gekennzeichnet, dass** der genannte festgelegte Schwellwert (42, 43, 44, 45, RS) gleich oder kleiner null ist.

3. Erkennungseinrichtung nach einem der Ansprüche 1 oder 2, **dadurch gekennzeichnet, dass** der genannte Wert, welcher das genannte Verhältnis (21, 22, 21 A, 22A, 21 B, 22B, R, f(R)) zwischen Werteänderungen abbildet, durch ein Winkelmaß (21, 21 A, 21 B) definiert ist, das von einer Tangente (22, 22A, 22B) an einem Punkt (25) der Überschreitung der Grenzkurve (8) durch ein Signal (24, 24A, 20B) bestimmt wird, welches Signal das genannte, den Wert des genannten elektrischen Stroms abbildende erste Signal und das genannte, die Steilheit des genannten elektrischen Stroms abbildende zweite Signal abbildet.

4. Erkennungseinrichtung nach irgendeinem der Ansprüche 1 bis 3, **dadurch gekennzeichnet, dass** die genannte Grenzkurve (18) durch mindestens zwei Abschnitte (28, 29) gebildet wird.

5. Erkennungseinrichtung nach Anspruch 4, **dadurch gekennzeichnet, dass** die Grenzkurve (18)

- einen ersten Abschnitt (28), der bei einem ersten Stromschwellwert (S1) beginnt, bei einem zweiten Stromschwellwert (S2) endet und mit einer ersten Achse (12) einen ersten Winkel (30) bildet, der einen Stromwert abbildet, sowie
- einen zweiten Abschnitt (29) umfasst, der bei dem genannten zweiten Schwellwert (S2) beginnt.

6. Erkennungseinrichtung nach Anspruch 5, **dadurch gekennzeichnet, dass** der zweite Abschnitt (29) mit der ersten Achse (12) einen zweiten Winkel (31) bildet, welcher zweite Winkel (31) größer ist als der erste Winkel (30).

7. Erkennungseinrichtung nach irgendeinem der Ansprüche 1 bis 3, **dadurch gekennzeichnet, dass** die genannte Grenzkurve (18) bei einem ersten Schwellwert (S1) beginnt und durch festgelegte Wertepaare definiert ist.

8. Erkennungseinrichtung nach irgendeinem der Ansprüche 1 bis 7, **dadurch gekennzeichnet, dass** die genannte Grenzkurve durch einen Bereich verläuft, der durch eine erste Kurve (34) und eine zweite Kurve (35) definiert ist, wobei die genannte erste Kurve (34) einen ersten Abschnitt (36), der bei einem ersten relativen Stromschwellwert (S4) beginnt, bei einem zweiten relativen Stromschwellwert (S5) endet und mit einer ersten Achse (12) einen ersten, einen Stromwert abbildenden Winkel (38) bildet, sowie einen zweiten Abschnitt (37) umfasst, der bei dem genannten zweiten relativen Schwellwert (S5) beginnt und mit der ersten Achse einen zweiten Winkel (63) bildet, welcher zweite Winkel größer ist als der erste Winkel, wobei die genannte zweite Kurve einen dritten Abschnitt (39), der bei einem dritten relativen Stromschwellwert (S6) beginnt, bei einem vierten relativen Stromschwellwert (S7) endet und mit einer ersten Achse (12) einen dritten, einen Stromwert abbildenden Winkel (41) bildet, sowie einen vierten Abschnitt (40) umfasst, der bei dem genannten vierten relativen Schwellwert (S7) beginnt und mit der ersten Achse einen vierten Winkel (64) bildet, wobei der dritte relative Schwellwert (S6) größer ist als der erste relative Schwellwert (S4), der vierte relative Schwellwert (S7) größer ist als der zweite relative Schwellwert (S5) und der der dritte Winkel (41) kleiner oder gleich dem ersten Winkel (38) ist.

9. Erkennungseinrichtung nach Anspruch 8, **dadurch gekennzeichnet, dass** in einem Orthonormalsystem in Bezug zu einem Nenn-Betriebsstrom:

   - der erste relative Schwellwert (S4) größer ist als 1,
   - der zweite relative Schwellwert (S5) größer ist als 3,3,
   - der dritte relative Schwellwert (S6) kleiner ist als 1,6,
   - der vierte relative Schwellwert (S7) kleiner ist als 5,3,
   - der erste Winkel (38) kleiner ist als 70 Grad und
   - der dritte Winkel (41) größer ist als 30 Grad.

10. Erkennungseinrichtung nach irgendeinem der Ansprüche 1 bis 9, **dadurch gekennzeichnet, dass** die genannte Grenzkurve (18) in einem ersten Quadranten (23) mit positiven Strom- und Stromsteilheitswerten sowie in einem dritten Quadranten (24) mit negativen Strom- und Stromsteilheitswerten annähernd symmetrisch ausgebildet ist.

11. Leistungsschalter mit Leistungskontakten (3) zur Abschaltung eines elektrischen Stroms in elektrischen Leitern (2) sowie mit einem elektronischen Auslöser (60), der Stromwandler (4, 4A, 4B, 4C) zur Lieferung von Signalen, welche in den elektrischen Leitern fließende Ströme abbilden, und Verarbeitungsmittel zur Verarbeitung der Auslösefunktion (6, 7, 61) umfasst, welche die genannten, in den elektrischen Leitern fließende Ströme abbildenden Signale aufnehmen und ein Auslösesignal (8) an ein Auslöserelais (9) zur Abschaltung der genannten elektrischen Kontakte liefern, **dadurch gekennzeichnet, dass** der Auslöser (60) mindestens eine Einrichtung (7) zur Kurzschlusserkennung nach irgendeinem der Ansprüche 1 bis 10 umfasst, um bei Erkennung eines Kurzschlusses ein Auslösesignal (8) zu liefern.

12. Verfahren zur Kurzschlusserkennung, umfassend

   - einen ersten Schritt (51) zur Bestimmung eines ersten Werts eines ersten Signals (i, ia, lb; ic, i(n)), das den Wert eines elektrischen Stroms abbildet, sowie zur Bestimmung eines zweiten Werts eines zweiten Signals (di/dt, dia/dt, dib/dt; dic/dt, di(n)), das die Steilheit des genannten elektrischen Stroms abbildet,
   - einen Schritt (52) zur Überprüfung des Überschreitens einer Grenzkurve (18) durch den genannten ersten Wert und den genannten zweiten Wert,
   - einen zweiten Schritt (53) zur Bestimmung eines Werts, der ein Verhältnis (R) zwischen Änderungen des genannten zweiten Werts des genannten zweiten Signals und Änderungen des genannten ersten Werts des ersten Signals abbildet, sowie
   - einen Schritt (54) zur Überprüfung des Werts, welcher das genannte Verhältnis (R, f(R)) zwischen Werteänderungen abbildet, um einen Kurzschluss-Erkennungsbefehl auszugeben, wenn der genannte, ein Verhältnis abbildende Wert einen festgelegten Schwellwert (RS) überschreitet.

13. Erkennungsverfahren nach Anspruch 12, **dadurch gekennzeichnet, dass** im zweiten Bestimmungsschritt (53) der das genannte Verhältnis (R) abbildende Wert in Abhängigkeit von

   - einer ersten Differenz (di(n) - di(n-1)) zwischen einem nahe an einem Zeitpunkt der Überschreitung der Kurve liegenden Abtastwert (di(n)) des genannten zweiten Signals und einem der vorausgehenden Abtastwerte (di(n1)) des genannten zweiten Signal sowie
   - einer zweiten Differenz (i(n)-i(n-1)) zwischen einem nahe am genannten Zeitpunkt der Überschreitung der Kurve liegenden Abtastwert (di(n)) des genannten ersten Signals und einem der vorausgehenden Abtastwerte (i(n-1)) des genannten ersten Signal bestimmt wird.

14. Erkennungsverfahren nach einem der Ansprüche 12 oder 13, **dadurch gekennzeichnet, dass** im zweiten Bestimmungsschritt (53) der das genannte Verhältnis (R) abbildende Wert (f(R)) eine Tangente abbildet, die etwa zu dem Zeitpunkt gebildet wird, zu dem die Grenzkurve durch eine Kurve geschnitten wird, die das erste Signal und das zweite Signal in einem annähernd orthogonalen System abbildet.

15. Erkennungsverfahren nach einem der Ansprüche 12 oder 13, **dadurch gekennzeichnet, dass** im zweiten Bestimmungsschritt (53) der das genannte Verhältnis (R) abbildende Wert (f(R)) einen Winkel (21, 21 A, 21 B) abbildet, welcher Winkel durch einen Vektor, der eine Tangente (22, 22A, 22B) etwa zum Zeitpunkt abbildet, zu dem die Grenzkurve (18) durch eine, das erste Signal und das zweite Signal in einem annähernd orthogonalen System abbildende Kurve (20, 20A, 20B) geschnitten wird, und einen parallel zu einer Achse (12) verlaufenden, Stromwerte abbildenden Vektor gebildet wird.

16. Erkennungsverfahren nach irgendeinem der Ansprüche 12 bis 15, **dadurch gekennzeichnet, dass** im Schritt (18) zur Überprüfung des Überschreitens einer Grenzkurve (18) die Grenzkurve mindestens zwei Abschnitte (28, 29) umfasst.

17. Erkennungsverfahren nach irgendeinem der Ansprüche 12 bis 16, **dadurch gekennzeichnet, dass** im Schritt (52) zur Überprüfung des Überschreitens einer Grenzkurve (18) die Grenzkurve durch bestimmte Wertepaare definiert ist.

**FIG. 1 (Art Antérieur)**

**FIG. 2 (Art Antérieur)**

**FIG. 3**

**FIG. 4**

15

**FIG. 5**

**FIG. 6**

**FIG. 7**

**FIG. 8**

**FIG. 9**

**FIG. 10**

Acquisition de signaux
de courant — 50

i(n) , di(n) — 51

Dépassement
de la limite ? — 52      NON

OUI

$$R = \frac{di(n) - di(n-1)}{i(n) - i(n-1)}$$ — 53

F(R) ≥ RS ? — 54      NON

OUI

Détection de
court-circuit — 55

**FIG. 11**

**FIG. 12**

## RÉFÉRENCES CITÉES DANS LA DESCRIPTION

**Documents brevets cités dans la description**

- DE 3642136
- EP 838887 A
- US 5905615 A
- DE 19839616
- WO 9903183 A
- US 6313639 B
- WO 99031183 A